# EUROPÄISCHE PATENTSCHRIFT

(11) **EP 2 794 332 B1**
(45) Veröffentlichungstag und Bekanntmachung des Hinweises auf die Patenterteilung: **29.04.2020**
(21) Anmeldenummer: 12813328.7
(22) Anmeldetag: 19.12.2012
(51) Int. Cl.: B60K 37/06, G06F 3/01, H03K 17/975

(54) **VERFAHREN ZUM BETREIBEN EINER SCHALTERANORDNUNG UND SCHALTERANORDNUNG**
METHOD FOR OPERATING A SWITCH ARRANGEMENT, AND SWITCH ARRANGEMENT
PROCÉDÉ PERMETTANT DE FAIRE FONCTIONNER UN SYSTÈME DE COMMUTATION ET ENSEMBLE DE COMMUTATION

(30) Priorität: 21.12.2011 DE 102011089400
(43) Veröffentlichungstag der Anmeldung: 29.10.2014
(73) Patentinhaber: Bayerische Motoren Werke Aktiengesellschaft, 80809 München (DE)
(72) Erfinder: LINDNER, Matthias, 82166 Gräfelfing (DE); TILLE, Thomas, 81249 München (DE)
(86) Internationale Anmeldenummer: PCT/EP2012/076150
(87) Internationale Veröffentlichungsnummer: WO 2013/092713

(56) Entgegenhaltungen:
- EP-A1- 2 372 915

## Beschreibung

Die Erfindung betrifft ein Verfahren zum Betreiben einer Schalteranordnung und eine Schalteranordnung.

In Kraftfahrzeugen werden dem Fahrer eine Vielzahl von Schaltern bereitgestellt, um Einheiten des Kraftfahrzeugs zu steuern, beispielsweise eine Einparkhilfe mit Abstandssensoren. Dazu sind herkömmlich Schalter bekannt, die keine Bedienhaptik aufweisen, beispielsweise Touchpads oder Touchscreens. Dabei können mehrere Schalter auf einer gemeinsamen Bedienfläche angeordnet sein.

Dokument EP 2 372 915 A1 offenbart eine Mensch/Maschine-Schnittstelle, insbesondere für ein Kraftfahrzeug. Die Schnittstelle umfasst ein berührungsempfindliches Mittel, das derart befestigt ist, dass es in seiner Gesamtheit bewegt werden kann in Bezug auf ein Gehäuse, wenn ein Druck auf das berührungsempfindliche Mittel ausgeübt wird. Die Schnittstelle umfasst in einer Ausführung ein Blockier-/Lösemittel. Wenn eine Gleitberührung auf dem berührungsempfindlichen Mittel erfasst wird, werden die Blocker-/Lösemittel nicht gelöst.

Es ist wünschenswert, ein Verfahren zum Betreiben einer Schalteranordnung sowie eine Schalteranordnung anzugeben, die zuverlässig betreibbar und eindeutig bedienbar ist.

Gegenstand der Erfindung ist gemäß einer Ausführungsform ein Verfahren zum Betreiben einer Schalteranordnung mit einer Betätigungsfläche. Die Betätigungsfläche weist einen vorgegebenen Schalterbereich auf. Der Schalterbereich weist einen aktiven Zustand und einen passiven Zustand auf. In dem aktiven Zustand ändert eine Betätigung des vorgegebenen Schalterbereichs einen Zustand einer zugeordneten Einheit. In dem passiven Zustand ändert die Betätigung des vorgegebenen Schalterbereichs den Zustand der zugeordneten Einheit nicht. Das Verfahren umfasst ein Ermitteln eines Bereichs der Betätigungsfläche, in dem die Betätigung der Schalteranordnung erfolgt. Der ermittelte Bereich wird mit dem vorgegebenen Schalterbereich verglichen. Der Zustand des Schalterbereichs wird ermittelt. Eine Bewegung der Betätigungsfläche in Antwort auf die Betätigung wird freigegeben, wenn der ermittelte Bereich mit dem vorgegebenen Schalterbereich korreliert und wenn dem ermittelten Zustand der aktive Zustand des Schalterbereichs zugeordnet ist. Die Bewegung der Betätigungsfläche wird in Antwort auf die Betätigung gesperrt, wenn der ermittelte Bereich nicht mit dem vorgegebenen Schalterbereich korreliert und/oder wenn dem ermittelten Zustand der passive Zustand des Schalterbereichs zugeordnet ist.

Die Bewegung der Bedienfläche wird nur dann freigegeben, wenn der ermittelte Bereich mit dem vorgegebenen Schalterbereich korreliert, also eine gültige Fingerposition bei der Betätigung erkannt wurde, und durch den Schalterbereich überhaupt ein Zustand der zugeordneten Einheit verändert werden kann. Somit wird dem Benutzer nur dann eine erfolgreiche Bedienung durch die haptische Rückmeldung suggeriert, wenn auch tatsächlich eine Funktion ausgelöst wurde, also beispielsweise der Zustand der zugeordneten Einheit geändert wurde. Die Betätigungsfläche ist nur dann bewegbar, wenn der vorgegebene Schalterbereich berührt wird und aktiv ist.

Wird die Betätigungsfläche außerhalb des Schalterbereichs betätigt, ist die Bewegung der Betätigungsfläche gesperrt. Somit wird dem Nutzer keine erfolgreiche Bedienung suggeriert, da keine haptische Rückmeldung in Form einer Bewegung der Betätigungsfläche erfolgt.

Wird zwar der vorgegebene Schalterbereich betätigt, dieser ist aber in seinem passiven Zustand, ist die Bewegung der Betätigungsfläche ebenfalls gesperrt. Der Schalterbereich ist beispielsweise in seinem passiven Zustand, wenn die zugeordnete Einheit zu dem Zeitpunkt der Betätigung nicht aktivierbar ist, beziehungsweise der Zustand nicht veränderbar ist.

Die zugeordnete Einheit ist gemäß Ausführungsformen eine Funktionseinheit, insbesondere eine Funktionseinheit eines Kraftfahrzeugs. Beispielsweise ist die Funktionseinheit ein zu- beziehungsweise abschaltbarer Tempomat.

Die zugeordnete Einheit ist gemäß Ausführungsformen eine Vorrichtung, insbesondere eine Vorrichtung eines Kraftfahrzeugs. Beispielsweise ist die Vorrichtung ein zubeziehungsweise abschaltbare Heckscheibenheizung.

Beispielsweise ist die zugeordnete Einheit ein Bergabfahr-Assistent eines Kraftfahrzeugs. Der Bergabfahr-Assistent ist nur dann aktivierbar, wenn das Kraftfahrzeug eine Geschwindigkeit von weniger als 30 km/h aufweist. Bewegt sich das Kraftfahrzeug schneller als 30 km/h ist die Bewegung der Betätigungsfläche auch dann gesperrt, wenn die Betätigung in dem vorgegebenen Schalterbereich erfolgt, also wenn der ermittelte Bereich mit dem vorgegebenen Schalterbereich korreliert. Bewegt sich das Kraftfahrzeug schneller als 30 km/h ist der Schalterbereich in seinem passiven Zustand.

Fährt das Kraftfahrzeug weniger als 30 km/h ist die Bewegung der Betätigungsfläche dann gesperrt, wenn der ermittelte Bereich nicht mit dem vorgegebenen Schalterbereich korreliert, also wenn die Betätigung durch den Nutzer außerhalb des vorgegebenen Schalterbereichs erfolgt.

Die Bewegung der Betätigungsfläche ist freigegeben, wenn das Kraftfahrzeug sich mit einer Geschwindigkeit von weniger als 30 km/h bewegt, da der Schalterbereich nun in seinem aktiven Zustand ist, und wenn die Betätigung in dem vorgegebenen Schalterbereich erfolgt, also der ermittelte Bereich mit dem vorgegebenen Schalterbereich korreliert. Bewegt sich das Kraftfahrzeug mit einer Geschwindigkeit von weniger als 30 km/h ist ein Zuschalten des Bergabfahr-Assistenten möglich, und dem Nutzer wird eine erfolgreiche Aktivierung durch die Bewegung der Betätigungsfläche bestätigt, wenn er auch den vorgegebenen Schalterbereich betätigt. Durch die Bewegung der Betätigungsfläche erfolgt eine haptische Rückmeldung, die die korrekte Aktivierung des Bergabfahr-Assistenten bestätigt.

Somit ist die Betätigungsfläche gemäß Ausführungsformen so angeordnet, dass sie eine haptische Rückmeldung durch Bewegung der gesamten Betätigungsfläche bereitstellt. Dabei wird die haptische Rückmeldung erzeugt, abhängig davon ob eine gültige Schalterposition auf der Betätigungsfläche betätigt wurde oder nicht. Damit ist es möglich, dass dem Nutzer eine erfolgreiche Bedienung nur dann suggeriert wird, wenn eine Einheit des Kraftfahrzeugs ausgelöst wurde. Eine Blindbedienung ist damit möglich.

Gegenstand der Erfindung ist gemäß einer weiteren Ausführungsform ein Verfahren zum Betreiben einer Schalteranordnung mit einer Betätigungsfläche, die eine Mehrzahl von vorgegebenen Schalterbereichen aufweist. Die Schalterbereiche der Mehrzahl der vorgegebenen Schalterbereiche weisen jeweils einen aktiven und einen passiven Zustand auf. In dem aktiven Zustand ändert jeweils eine Betätigung eines Schalterbereichs der Mehrzahl von vorgegebenen Schalterbereichen einen Zustand einer dem Schalterbereich zugeordneten Einheit. In dem passiven Zustand ändert jeweils die Betätigung des Schalterbereichs den Zustand der zugeordneten Einheit nicht. Das Verfahren umfasst ein Ermitteln eines Bereichs der Betätigungsfläche, in dem die Betätigung der Schalteranordnung erfolgt. Der ermittelte Bereich wird mit der Mehrzahl von vorgegebenen Schalterbereichen verglichen. Der Zustands zumindest eines Schalterbereichs der Mehrzahl der Schalterbereiche wird ermittelt. Eine Bewegung der Betätigungsfläche wird in Antwort auf die Betätigung freigegeben, wenn der ermittelte Bereich mit einem Schalterbereich der Mehrzahl von vorgegebenen Schalterbereichen korreliert und wenn dem ermittelten Zustand der aktive Zustand des einen Schalterbereichs zugeordnet ist. Die Bewegung der Betätigungsfläche in Antwort auf die Betätigung wird gesperrt, wenn der ermittelte Bereich nicht mit einem Schalterbereich der Mehrzahl von vorgegebenen Schalterbereichen korreliert und/oder wenn dem ermittelten Zustand des mit dem ermittelten Bereich korrelierenden Schalterbereichs der passive Zustand zugeordnet ist.

Die Betätigungsfläche weist die Mehrzahl von vorgegebenen Schalterbereichen auf, die jeweils zueinander verschiedene Zustände aufweisen können. Wenn die Betätigungsfläche beispielsweise vier vorgegebene Schalterbereiche aufweist, können zu einem Zeitpunkt zwei Schalterbereiche in ihrem aktiven Zustand und zwei in ihrem passiven Zustand sein. Erfolgt nun eine Betätigung in einem der Schalterbereiche, die in ihrem passiven Zustand sind, ist eine Bewegung der Betätigungsfläche nicht möglich und es wird keine haptische Rückmeldung gegeben. Erfolgt die Betätigung in einem der Schalterbereiche, die in ihrem aktiven Zustand sind, wird die Bewegung der Betätigungsfläche freigegeben, so dass eine haptische Rückmeldung über das Ändern des Zustands der zugeordneten Einheit erfolgt.

Jedem vorgegebenen Schalterbereich der Mehrzahl von Schalterbereichen ist zumindest eine Einheit einer Mehrzahl von Einheit zugeordnet. Somit ist die Bedienfläche beispielsweise dazu eingerichtet, den Zustand von vier Einheiten unabhängig voneinander zu ändern. Bei einer freigegebenen Bewegung der Betätigungsfläche bewegt sich die gesamte Betätigungsfläche, also auch die Schalterbereiche, die zum Zeitpunkt der Betätigung ihren passiven Zustand aufweisen. Die Bewegung ist nur dann freigegeben, wenn der ermittelte Bereich mit dem Schalterbereich korreliert, der in seinem aktiven Zustand ist.

Gemäß weiteren Ausführungsformen ist die dem vorgegebenen Schalterbereich zugeordnete Einheit aus einer Mehrzahl von dem vorgegebenen Schalterbereich zugeordneten Einheiten ausgewählt. Durch den vorgegebenen Schalterbereich kann der Zustand der Mehrzahl von dem vorgegebenen Schalterbereich zugeordneten Einheiten geändert werden. Insbesondere sind dem vorgegebenen Schalterbereich zu unterschiedlichen Zeitpunkten unterschiedliche Einheiten aus der Mehrzahl von dem vorgegebenen Schalterbereich zugeordneten Einheiten zugeordnet. Dazu weist die Schalteranordnung beispielsweise eine Anzeigevorrichtung auf, die die aktuell zugeordnete Einheit darstellt. Insbesondere wird die Zuordnung einmalig im Werk vor der Auslieferung des Kraftfahrzeugs festgelegt.

Gemäß Ausführungsformen umfasst das Freigeben der Bewegung ein Verändern einer Eigenschaft eines magnetorheologischen Elements. Insbesondere wird eine Viskosität einer magnetorheologischen Flüssigkeit verändert. Zum Sperren der Bewegung wird die Viskosität der magnetorheologischen Flüssigkeit erhöht. Zum Freigeben der Bewegung wird die Viskosität der magnetorheologischen Flüssigkeit verringert.

Gemäß weiteren Ausführungsformen wird die Festigkeit eines elektroaktiven Elastomers verändert. Zum Freigeben der Bewegung wird die Festigkeit des elektroaktiven Elastomers verringert.

Gemäß weiteren Ausführungsformen umfasst das Sperren das Aktivieren eines Elektromagnets, der über einen Hebel beziehungsweise einen Exzenter die Bewegung der Betätigungsfläche begrenzt.

Gemäß weiteren Ausführungsformen umfasst das Sperren der Bewegung ein Aktivieren eines Piezoelements oder eines Piezomotors (Ultraschallmotor), das über einen Hebel beziehungsweise einen Exzenter die Bewegung der Betätigungsfläche begrenzt.

Gemäß einer Ausführungsform der Erfindung umfasst eine Schalteranordnung eine Betätigungsfläche mit einem vorgegebenen Schalterbereich. Der vorgegebene Schalterbereich weist einen aktiven und einen passiven Zustand auf. Der vorgegebene Schalterbereich ist so ausgebildet, dass eine Betätigung des vorgegebenen Schalterbereichs in dem aktiven Zustand einen Zustand einer dem Schalterbreich zugeordneten Einheit ändert. Der Schalterbereich ist so ausgebildet, dass die Betätigung des vorgegebenen Schalterbereichs den Zustand der zugeordneten Einheit in dem passiven Zustand nicht ändert. Die Schalteranordnung umfasst weiterhin ein Sperrelement, das mit der Betätigungsfläche mechanisch gekoppelt ist. Die Schalteranordnung umfasst eine Steuervorrichtung, die ausgebildet ist zum Ermitteln eines Bereichs der Betätigungsfläche, in dem eine Betätigung der Schalteranordnung erfolgt. Die Steuervorrichtung ist weiterhin ausgebildet zum Vergleichen des ermittelten Bereichs mit dem vorgegebenen Schalterbereich der Betätigungsfläche. Durch die Steuervorrichtung ist der Zustand des vorgegebenen Schalterbereichs ermittelbar. Die Steuervorrichtung ist ausgebildet zum Freigeben des Sperrelements, so dass eine Bewegung der Betätigungsfläche in Antwort auf die Betätigung freigegeben ist, wenn der ermittelte Bereich mit dem vorgegebenen Schalterbereich korreliert und wenn dem ermittelten Zustand des Schalterbereichs der aktive Zustand zugeordnet ist. Die Steuervorrichtung ist ausgebildet zum Aktivieren des Sperrelements, so dass die Bewegung der Betätigungsfläche in Antwort auf die Betätigung gesperrt ist, wenn der ermittelte Bereich nicht mit dem vorgegebenen Schalterbereich korreliert und/oder wenn dem ermittelten Zustand des vorgegebenen Schalterbereichs der passive Zustand zugeordnet ist.

Durch das Sperrelement ist es möglich, dass eine Bewegung der Betätigungsfläche nur dann möglich ist, wenn die Betätigung der Betätigungsfläche in dem vorgegebenen Schalterbereich erfolgt, und der Zustand der zugeordneten Einheit veränderbar ist. Dadurch, dass das Sperrelement die Bewegung der Betätigungsfläche freigibt, wird eine haptische Rückmeldung der Betätigung ermöglicht.

Das Sperrelement verhindert eine Bewegung der Betätigungsfläche, wenn der Zustand der zugeordneten Einheit nicht veränderbar ist, auch wenn der ermittelte Bereich mit dem vorgegebenen Schalterbereich korreliert. Ist die Betätigung außerhalb des vorgegebenen Schalterbereichs, sperrt das Sperrelement die Bewegung der Betätigungsfläche. Somit wird dem Benutzer durch die haptische Rückmeldung nur dann eine erfolgreiche Betätigung suggeriert, wenn auch tatsächlich der Zustand der zugeordneten Einheit verändert wird.

Gemäß weiteren Ausführungsformen umfasst die Betätigungsfläche eine Mehrzahl von vorgegebenen Schalterbereichen. Die Schalterbereiche der Mehrzahl von vorgegebenen Schalterbereichen weisen jeweils einen aktiven und einen passiven Zustand auf. Den Schalterbereichen der Mehrzahl von vorgegebenen Schalterbereichen ist jeweils zumindest eine Einheit zugeordnet. Die Steuervorrichtung ist ausgebildet zum Vergleichen des ermittelten Bereichs mit der Mehrzahl von vorgegebenen Schalterbereichen. Das Sperrelement ist freigegeben, wenn der ermittelte Bereich mit einem der vorgegebenen Schalterbereiche korreliert und wenn dem ermittelten Zustand des einen der vorgegebenen Schalterbereiche der aktive Zustand zugeordnet ist. Das Sperrelement ist aktiviert, wenn der ermittelte Bereich nicht mit einem der vorgegebenen Schalterbereiche korreliert und/oder wenn dem ermittelten Zustand des mit dem ermittelten Bereich korrelierenden Schalterbereichs der passive Zustand zugeordnet ist.

Somit ist es möglich, auch bei einer Betätigungsfläche, die eine Mehrzahl von Schalterbereichen aufweist, nur dann eine haptische Rückmeldung zu erzeugen, wenn tatsächlich der Zustand zumindest der einen Einheit verändert wird.

Gemäß Ausführungsformen umfasst das Sperrelement ein magnetorheologisches Element, beispielsweise eine magnetorheologische Flüssigkeit oder ein elektroaktives Elastomer.

Gemäß weiteren Ausführungsformen umfasst das Sperrelement einen Elektromagnet mit einem Hebel beziehungsweise Exzenter, der mit der Betätigungsfläche gekoppelt ist.

Gemäß weiteren Ausführungsformen umfasst das Sperrelement ein Piezoelement oder einen Piezomotor (Ultraschallmotor) mit einem Hebel beziehungsweise Exzenter, der mit der Betätigungsfläche gekoppelt ist.

Gemäß Ausführungsformen umfasst die Schalteranordnung eine Anzeigevorrichtung, die mit dem vorgegebenen Schalterbereich gekoppelt ist zur Darstellung der zugeordneten Einheit.

Gemäß Ausführungsbeispielen ist es somit möglich, die Anzeigevorrichtung nur dann in dem vorgegebenen Schalterbereich darzustellen, wenn der Schalterbereich in seinem aktiven Zustand ist.

Gemäß einem Aspekt der Erfindung umfasst ein Kraftfahrzeug eine solche Schalteranordnung und die zugeordnete Einheit ist eine Einheit des Kraftfahrzeugs. Beispielsweise ist die Einheit eines aus: eine Kamera, ein Bergabfahr-Assistent, ein Fahrwerks-Assistent, eine Parkhilfe mit Abstandssensoren, ein Tempomat und ein Nebelscheinwerfer. Die Einheit kann auch eine weitere Einheit des Kraftfahrzeugs sein, beispielsweise ein Schiebedach des Kraftfahrzeugs.

Weitere Vorteile, Merkmale und Weiterbildungen ergeben sich aus den nachfolgenden in Verbindung mit den Figuren erläuterten Beispielen. Gleiche, gleichartige und gleich wirkende Elemente können in den Figuren mit den gleichen Bezugszeichen versehen sein. Die dargestellten Elemente und deren Größenverhältnisse zueinander sind grundsätzlich nicht als maßstabsgerecht anzusehen.

Es zeigen:
- Figur 1: eine schematische Darstellung eines Kraftfahrzeugs gemäß einer Ausführungsform,
- Figur 2: eine schematische Ansicht einer Schalteranordnung gemäß einer Ausführungsform,
- Figuren 3A bis 3C: eine schematische Darstellung einer Betätigungsfläche gemäß einer Ausführungsform,
- Figur 4: eine schematische Darstellung einer Schalteranordnung im Querschnitt gemäß einer Ausführungsform,
- Figur 5: eine schematische Darstellung einer Schalteranordnung im Querschnitt gemäß einer Ausführungsform, und
- Figur 6: eine schematische Darstellung eines magnetorheologischen Elements gemäß einer Ausführungsform.

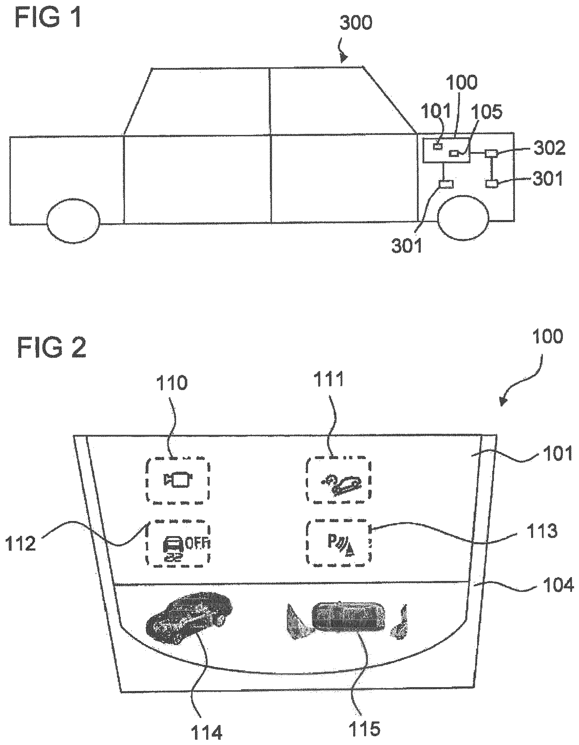

Figur 1 zeigt eine schematische Darstellung eines Kraftfahrzeugs 300. Das Kraftfahrzeug 300 weist eine Schalteranordnung 100 auf, die eine Betätigungsfläche 101 und eine Steuervorrichtung 105 aufweist. Die Steuervorrichtung 105 ist eingerichtet, die Schalteranordnung 101 zu steuern.

Die Schalteranordnung 101 ist gemäß Ausführungsformen mit einer Steuerung 302 des Kraftfahrzeugs 300 gekoppelt. Die Steuerung 302 ist beispielsweise eingerichtet, eine Einheit 301 des Kraftfahrzeugs 300 zu steuern. Gemäß weiteren Ausführungsformen ist die Schalteranordnung 100 direkt mit der Einheit 301 gekoppelt. Insbesondere ist die Schalteranordnung 100 gemäß Ausführungsformen mit einer Mehrzahl von unterschiedlichen Einheiten 301 des Kraftfahrzeugs 300 gekoppelt. Insbesondere ist der Steuerung 302 beziehungsweise der Steuervorrichtung 105 bekannt, ob der Zustand der zugeordnete Einheit 301 veränderbar ist. Insbesondere ist der Steuerung 302 beziehungsweise der Steuervorrichtung 105 zum Zeitpunkt der Betätigung des Betätigungsfläche 101 bekannt, ob der Zustand der zugeordnete Einheit 301 zu dem Zeitpunkt veränderbar ist.

Die Einheiten 301 können jeweils durch eine Betätigung der Schalteranordnung 100gesteuert werden, und insbesondere ist der jeweilige Zustand der Einheit 301 durch eine Betätigung der Schalteranordnung 100 veränderbar. Beispielsweise ist durch eine Betätigung der Schalteranordnung die Einheit 301 zu- beziehungsweise abschaltbar.

Die Einheit 301 ist gemäß Ausführungsformen eine Vorrichtung des Kraftfahrzeugs 300. Die Vorrichtung ist insbesondere eine Hardwarekomponente des Kraftfahrzeugs 300, deren Zustand veränderbar ist. Beispielsweise ist die Vorrichtung ein Audiosystem des Kraftfahrzeugs 300, das über die Schalteranordnung an- beziehungsweise ausschaltbar ist.

Die Einheit 301 ist gemäß Ausführungsformen eine Funktionseinheit des Kraftfahrzeugs 300. Die Funktionseinheit ist insbesondere eine Softwarekomponente des Kraftfahrzeugs 300, die beispielsweise mittels einer Steuervorrichtung des Kraftfahrzeugs realisiert ist. Beispielsweise ist die Funktionseinheit eine Klimaanlagenautomatik des Kraftfahrzeugs 300, die über die Schalteranordnung anbeziehungsweise ausschaltbar ist.

Figur 2 zeigt eine schematische Darstellung der Schalteranordnung 100. Die Schalteranordnung 100 weist die Betätigungsfläche 101 auf, die eine Mehrzahl von Schalterbereichen 110, 111, 112, 113, 114 und 115 aufweist.

Die Schalterbereiche 110 bis 115 sind getrennt voneinander auf der Oberfläche der Betätigungsfläche 101 angeordnet. Jeweils einem Schalterbereich der Schalterbereiche 110 bis 115 ist eine Einheit der Einheiten 301 zugeordnet. Beispielsweise ist dem Schalterbereich 110 eine Kamera zugeordnet, dem Schalterbereich 111 ein Bergabfahr-Assistent, dem Schalterbereich 112 ein elektronisches Stabilitätsprogramm, dem Schalterbereich 113 eine Einparkhilfe mit Abstandsensoren, dem Schalterbereich 114 eine Antriebssteuerung und dem Schalterbereich 115 eine Abstandsmessung.

Die Betätigungsfläche 101 ist relativ zu einem Gehäuse 104 der Schalteranordnung 100 beweglich. Insbesondere ist die Betätigungsfläche 101 relativ zu dem Gehäuse 104 quer zur Hauptausbreitungsrichtung der Betätigungsfläche 101 beweglich. Insbesondere ist die Betätigungsfläche 101 relativ zu dem Gehäuse 104 in etwa senkrecht zur Hauptausbreitungsrichtung der Betätigungsfläche 101 beweglich. Die Betätigungsfläche 101 ist durch eine Betätigung relativ zu dem Gehäuse 104 versenkbar.

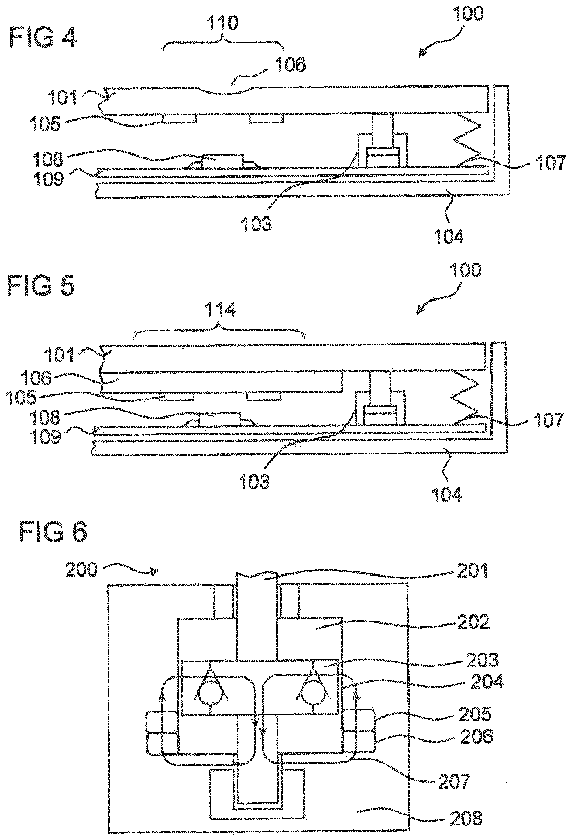

Zwischen der Betätigungsfläche 101 und dem Gehäuse 104 ist ein Sperrelement 103 (Figuren 4 und 5) angeordnet, das eingerichtet ist, die Bewegung zwischen der Betätigungsfläche 101 und dem Gehäuse 104 zu verhindern. Insbesondere ist das Sperrelement 103 mit der Steuervorrichtung 105 gekoppelt. Die Steuervorrichtung 105 ist ausgebildet, das Sperrelement 103 so anzusteuern, dass es die Bewegung der Betätigungsfläche 101 relativ zum Gehäuse 104 verhindert und in einem weiteren Zustand des Sperrelements 103 die Bewegung der Betätigungsfläche 101 relativ zu dem Gehäuse 104 freigegeben ist.

Um den Zustand der zugeordnete Einheit 301 zu ändern betätigt ein Nutzer beispielsweise den Schalterbereich 110 der Betätigungsfläche 101. Durch den Schalterbereich 110 ist beispielsweise eine Kamera des Kraftfahrzeugs 300 zubeziehungsweise abschaltbar, die ein Gebiet außerhalb des Kraftfahrzeugs 300 aufzeichnet. Die Betätigung des Schalterbereichs 100 erfolgt beispielsweise durch den Nutzer mittels eines Aufdrücken eines Fingers.

Der Zustand der Kamera, also beispielsweise ein Einschalten, wird nur dann geändert, wenn der Benutzer die Betätigungsfläche 101 im Bereich 110 betätigt. Ein Drücken der Betätigungsfläche 101 außerhalb des Bereichs 110 führt nicht zu einer Veränderung des Zustands der Kamera. Wenn der Benutzer den Bereich 110 trifft und die Betätigungsfläche 101 relativ zum Gehäuse 104 drückt, ist die Bewegung der Betätigungsfläche 101 durch das Sperrelement 103 freigegeben, so dass sich die Betätigungsfläche 101 relativ zu dem Gehäuse 104 bewegt, und dem Nutzer somit eine haptische Rückmeldung gegeben wird. Dem Benutzer wird somit ein erfolgreiches Verändern des Zustands der Kamera haptisch durch die Bewegung der Betätigungsfläche 101 relativ zu dem Gehäuse 104 bestätigt.

Berührt der Benutzer die Betätigungsfläche 101 außerhalb der vorgegebenen Bereiche 110 bis 115, also insbesondere außerhalb des Bereichs 110, ist durch die Berührung keine Veränderung des Zustands der Kamera möglich. Das Sperrelement 103 verhindert eine Bewegung der Betätigungsfläche 101 relativ zu dem Gehäuse 104, so dass dem Benutzer signalisiert wird, dass er den Zustand der Kamera nicht ändert.

Zusätzlich ist die Bewegung der Betätigungsfläche 101 relativ zu dem Gehäuse 104 durch die Steuervorrichtung 105 mit dem Sperrelement 103 auch dann gesperrt, wenn die Einheit 301 die dem betätigten Schalterbereich zugeordnet ist, zu dem Zeitpunkt der Betätigung nicht veränderbar ist. Der Schalterbereich, dem die Einheit 301 zugeordnet ist, ist in seinem passiven Zustand. Beispielsweise ist die Einparkhilfe, die dem Schalterbereich 113 zugeordnet ist, nur dann einschaltbar, wenn das Kraftfahrzeug sich langsamer als eine vorgegebene Geschwindigkeit bewegt.

Bewegt sich das Kraftfahrzeug 300 schneller als die vorgegebene Geschwindigkeit, ist die Einparkhilfe nicht zuschaltbar und der Schalterbereich 113 ist in seinem passiven Zustand. Eine Berührung des Schalterbereichs 113 und ein Einwirken einer Kraft durch den Finger in den Schalterbereich 113 ändert nicht den Zustand der Einparkhilfe. Das Sperrelement 103 sperrt die Bewegung der Betätigungsfläche 101 relativ zu dem Gehäuse 104, um dem Nutzer zu signalisieren, dass durch seine Betätigung der Zustand nicht geändert wird.

Bewegt sich das Kraftfahrzeug langsamer als die vorgegebene Geschwindigkeit, ist der Schalterbereich 113 in seinem aktiven Zustand und die Einparkhilfe durch eine Betätigung des Schalterbereichs 113 zuschaltbar. Das Sperrelement 103 gibt die Bewegung der Betätigungsfläche 101 relativ zu dem Gehäuse 104 frei, so dass dem Benutzer eine haptische Rückmeldung gegeben wird, die ihm das erfolgreiche Einschalten der Einparkhilfe bestätigt.

Die Schalterbereiche 110 bis 113 sind auf einer gemeinsamen geschlossenen Bedienoberfläche der Betätigungsfläche 101 angeordnet. Insbesondere in den Bereichen 110 bis 113 ist die Bedienoberfläche sensitiv zur Fingererkennung. Zwischen den Bereichen 110 und 113 ist gemäß Ausführungsformen keine Fingererkennung möglich und insbesondere keine Funktionsauslösung, so dass eine Berührung der Bedienoberfläche zwischen den Schalterbereichen 110 bis 113 keine Bewegung der Betätigungsfläche 101 relativ zu dem Gehäuse 104 zur Folge hat. Gemäß weiteren Ausführungsformen ist die gesamte Bedienoberfläche der Betätigungsfläche 101 sensitiv zur Berührungserkennung.

Wird einer der Schalterbereich 110 bis 113 betätigt und ist dieser betätigte Schalterbereich in seinem aktiven Zustand wird die Bewegung der gesamten Bedienoberfläche der Betätigungsfläche 101 freigegeben, so dass sich auch die weiteren Schalterbereiche der Schalterbereiche 110 bis 113 mitbewegen. Gemäß Ausführungsformen ist die Zuordnung zwischen den Schalterbereichen 110 bis 113 mit den jeweils zugeordneten Einheiten fest vorgegeben und während des Betriebs der Schalteranordnung 100 beziehungsweise des Kraftfahrzeugs 300 nicht veränderbar.

Die Schalterbereiche 114 und 115 sind gemäß Ausführungsformen auf einer gemeinsamen geschlossenen Bedienoberfläche angebracht, die vergleichbar mit der Bedienoberfläche der Schalterbereiche 110 bis 113 funktioniert. Im Unterschied zu den Schalterbereichen 110 bis 113 ist die Zuordnung der Einheit 301 zu dem Schalterbereich 114 und dem Schalterbereich 115 jeweils veränderbar. Beispielsweise sind dem Schalterbereich 115 in einem Kraftfahrzeug mit Abstandsensoren lediglich im Rückbereich des Kraftfahrzeugs als Einheit 301 diese Abstandsensoren zugeordnet und dies wird im Schalterbereich 115 entsprechend dargestellt. In einem weiteren Kraftfahrzeug, das Abstandsensoren sowohl im Vorder- als auch im Rückbereich des Kraftfahrzeugs aufweist, sind sowohl die Abstandsensoren im Front- als auch die Sensoren im Rückbereich dem Schalterbereich 115 zugeordnet und dies wird im Schalterbereich 115 entsprechend unterschiedlich dargestellt, beispielsweise durch eine Anzeigevorrichtung 106 (Figur 5).

Gemäß Ausführungsformen sperrt das Sperrelement 103 die Bewegung der Betätigungsfläche 101 relativ zu dem Gehäuse 104 in seinem Ausgangszustand, bis eine Betätigung in einem der vorgegebenen Schalterbereiche 110 bis 115 erfolgt, der in seinem aktiven Zustand ist. Dann wird die Bewegung der Betätigungsfläche 101 freigegeben und, wenn sich die Betätigungsfläche 101 wieder in seiner Ruheposition relativ zu dem Gehäuse 104 befindet, die Bewegung wieder gesperrt.

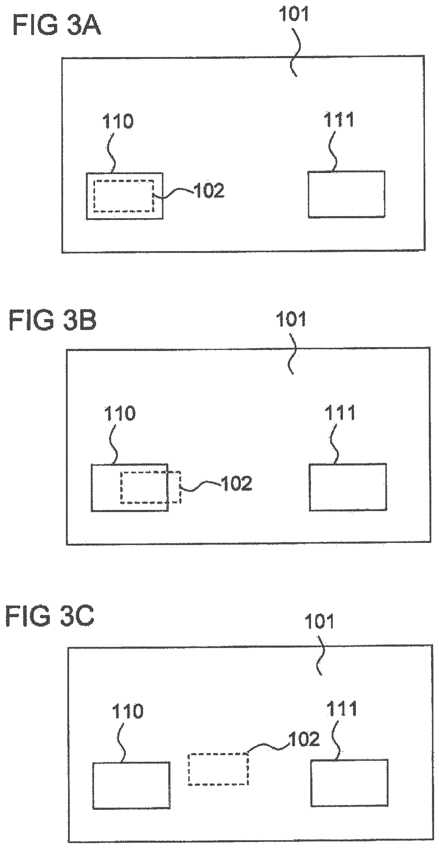

Figuren 3A bis 3C zeigt eine schematische Darstellung der Betätigungsfläche 101 mit dem Schalterbereich 110. Bei einer Betätigung der Schalteranordnung 100 durch einen Nutzer mittels Drücken des Fingers auf die Betätigungsfläche 101 wird durch eine Fingererkennungssensorik ein Bereich 102 ermittelt, in dem der Nutzer die Betätigungsfläche 101 betätigt. Die Fingererkennungssensorik ist beispielsweise Teil der Steuervorrichtung 105. Um zu erkennen ob und welcher Schalterbereich der Schalterbereiche 110 bis 115 durch den Nutzer betätigt wird, wird der ermittelte Bereich 102 mit dem Schalterbereich 110 bis 115 verglichen, in der beispielhaften Darstellung der Figuren 3A bis 3C mit dem Schalterbereich 110.

Liegt der Bereich 102 vollständig in dem Bereich 110, wie in der Figur 3A dargestellt, wird die Bewegung der Betätigungsfläche 101 freigegeben, wenn sich der Schalterbereich 110 in seinem aktiven Zustand befindet.

In Figur 3B liegt der ermittelte Bereich teilweise in dem Schalterbereich 110 und teilweise außerhalb des Schalterbereichs 110. Die Bewegung der Betätigungsfläche 101 wird freigegeben, wenn der ermittelte Bereich 102 und der Schalterbereich 110 mindestens einen vorgegebenen Korrelationsgrad aufweisen. Beispielsweise korreliert der ermittelte Bereich 102 mit dem Schalterbereich 110, wenn der Teil des ermittelten Bereichs 102, der mit dem Schalterbereich 110 überlappt, größer ist, als der andere Teil des ermittelten Bereichs 102, der außerhalb des Schalterbereichs 110 liegt. Gemäß weiteren Ausführungsformen ist ein anderer Korrelationsgrad vorgegeben, beispielsweise korreliert der ermittelte Bereich 102 mit dem Schalterbereich 110, wenn der Teil des ermittelten Bereichs 102, der mit dem Schalterbereich 110 überlappt, mindestens 70 % des ermittelten Bereichs 102 beträgt. Gemäß weiteren Ausführungsformen korreliert der ermittelte Bereich 102 mit dem Schalterbereich 110, wenn der Teil des ermittelten Bereichs 102, der mit dem Schalterbereich 110 überlappt, größer ist als ein weiterer Teil des ermittelten Bereichs 102, der mit einem anderen der Schalterbereich 111 bis 115 überlappt.

Liegt der ermittelte Bereich 102 vollständig außerhalb des Schalterbereichs 110, wie in Figur 3C dargestellt, liegt gemäß Ausführungsformen keine Korrelation vor und die Bewegung der Betätigungsfläche 101 relativ zu dem Gehäuse 104 bleibt gesperrt. Weiterhin liegt keine Korrelation vor und die Bewegung der Betätigungsfläche 101 relativ zu dem Gehäuse 104 bleibt gesperrt, wenn der ermittelte Bereich 102 mit zwei oder mehr Schalterbereiche gleichartig korreliert. Figur 4 zeigt einen schematischen Querschnitt durch die Schalteranordnung 100 gemäß Ausführungsformen. Zwischen der Betätigungsfläche 101 und dem Gehäuse 104 beziehungsweise einer Leiterplatte 109, die mit dem Gehäuse 104 gekoppelt ist, ist das Sperrelement 103 angeordnet. Eine Feder 107 ist angeordnet, um eine Federkraft in Richtung weg von der Leiterplatte 109 auf die Betätigungsfläche 101 auszuwirken.

Die Steuervorrichtung 105 ist ausgebildet, das Sperrelement 103 zu steuern und eine Betätigung durch den Nutzer zu erkennen. Die Anzeigevorrichtung 106 ist im gezeigten Ausführungsbeispiel eine Einkerbung in der Oberfläche der Betätigungsfläche 101 innerhalb des Schalterbereichs 100. Die Schalteranordnung 100 weist weiterhin eine Beleuchtung 108 auf, um den Schalterbereich 110 zu hinterleuchten.

Das Sperrelement 103 ist so angeordnet, dass es eine Bewegung der Betätigungsfläche 101 relativ zu dem Gehäuse 104 in Richtung zu der Leiterplatte 109 verhindern kann. Die Feder 107 bewegt die Betätigungsfläche 101 nach einem Eindrücken der Betätigungsfläche 101 relativ zu dem Gehäuse 104 wieder in den Ruhezustand.

Figur 5 zeigt die Schalteranordnung 100 im Querschnitt gemäß weiteren Ausführungsformen mit variabler Zuordnung zu dem Schalterbereich 114. Die Ausführungsformen der Figur 5 entsprechen im Wesentlichen den Ausführungsformen der Figur 4. Im Unterschied zu Figur 4 ist die Anzeigevorrichtung 106 auf der der Leiterplatte 109 zugewandten Seite der Betätigungsfläche 101 angeordnet und beispielsweise als Display ausgebildet. Das Display zeigt ein Symbol an, das die derzeitig zugeordnete Einheit 301 darstellt. Die Einkerbung in der Oberfläche der Betätigungsfläche 101 kann zusätzlich zu dem Display vorgesehen sein, die Oberfläche kann auch eben ausgebildet sein.

Das Sperrelement 103 ist so ausgebildet, dass es schnell zwischen dem gesperrten und dem ungesperrten Zustand schalten kann, so dass nur geringe bis keine Wartezeiten bei der Bedienung der Schalteranordnung 100 auftreten. Insbesondere ist das Sperrelement 103 elektronisch steuerbar.

Gemäß Ausführungsformen umfasst das Sperrelement 103 ein magnetorheologisches Element, wie beispielsweise eine magnetorheologische Flüssigkeit oder ein magnetorheologisches Elastomer. Die Viskosität beziehungsweise die Festigkeit des magnetorheologischen Elements ist über ein externes Magnetfeld steuerbar. Die Viskosität beziehungsweise Festigkeit ist sehr schnell veränderbar und die Sperrwirkung ist auch unter Druck lösbar.

Gemäß weiteren Ausführungsformen umfasst das Sperrelement 103 einen Elektromagnet, der mit einem Hebel beziehungsweise mit einem Exzenter mit der Betätigungsfläche 101 gekoppelt ist. Die Bewegung der Betätigungsfläche 101 relativ zu dem Gehäuse wird durch den Hebel beziehungsweise den Exzenter gesperrt. Statt des Elektromagneten kann auch ein Piezoelement oder ein Ultraschallmotor vorgesehen sein.

Figur 6 zeigt eine schematische Darstellung des Sperrelement 103 mit einem magnetorheologischen Element 200 gemäß Ausführungsformen.

Das magnetorheologische Element 200 weist eine Kopplung 201 auf zur Kopplung mit der Betätigungsfläche 101. Das magnetorheologische Element 200 weist ein ferromagnetisches Metallgehäuse 208 auf. In einer Ausnehmung des Metallgehäuses 208 ist eine magnetorheologische Flüssigkeit 202 angeordnet. Ein Kolben oder mehrere Kolben 203 sind innerhalb der magnetorheologischen Flüssigkeit 202 angeordnet. Die Kolben 203 weisen jeweils richtungsabhängige Durchlassöffnungen auf. Bei Bewegung der Betätigungsfläche 101 in Richtung weg von der Leiterplatte 109 (Figuren 4 und 5) kann die magnetorheologische Flüssigkeit 202 stets die Durchlassöffnungen durchströmen. Bei Bewegung der Betätigungsfläche 101 in Richtung der Leiterplatte 109 muss das Feld eines Permanentmagneten 205 durch eine Elektromagneten beziehungsweise eine Spule 206 aufgehoben werden, um die Bewegung freizugeben. Somit ist die Schalteranordnung 100 stromlos gesperrt. Zwischen dem Kolben 203 und dem Gehäuse 208 ist ein Luftspalt 204 angeordnet. Schematisch sind Magnetfeldlinien 207 des Permanentmagneten dargestellt.

Durch die Schalteranordnung 100, bei der die Bewegung der Betätigungsfläche 101 situativ gesperrt ist, ist die Bediensicherheit und der Bedienkomfort der Schalteranordnung 100 erhöht. Es wird nur dann eine haptische Rückmeldung durch die Bewegung der Betätigungsfläche 101 gegeben, wenn der Zustand der entsprechenden zugeordneten Einheit 301 tatsächlich verändert wird. Dies ist sowohl bei einer festen als auch bei einer flexiblen veränderbaren Tastenbelegung oder Displays beziehungsweise Touchpads möglich.

### Bezugszeichen:

- 100: Schalteranordnung
- 101: Betätigungsfläche
- 110-115: Schalterbereich
- 102: ermittelter Bereich
- 103: Sperrelement
- 104: Gehäuse
- 105: Steuervorrichtung
- 106: Anzeigevorrichtung
- 107: Feder
- 108: Beleuchtung
- 109: Leiterplatte
- 200: Magnetorheologisches Element
- 201: Kopplung
- 202: magnetorheologische Flüssigkeit
- 203: Kolben
- 204: Luftspalt
- 205: Permanentmagnet
- 206: Spule
- 207: Magnetfeldlinien
- 208: Gehäuse
- 300: Kraftfahrzeug
- 301: Einheit
- 302: Steuerung

## Patentansprüche

1. Verfahren zum Betreiben einer Schalteranordnung (100) mit einer Betätigungsfläche (101) mit einem vorgegebenen Schalterbereich (110) mit einem aktiven Zustand, in dem eine Betätigung des vorgegebenen Schalterbereichs (110) einen Zustand einer zugeordneten Einheit (301) ändert, und einem passiven Zustand, in dem die Betätigung des vorgegebenen Schalterbereichs (110) den Zustand der zugeordneten Einheit (301) nicht ändert, umfassend:
- Ermitteln eines Bereichs (102) der Betätigungsfläche (101), in dem die Betätigung der Schalteranordnung (100) erfolgt,
- Vergleichen des ermittelten Bereichs (102) mit dem vorgegebenen Schalterbereich (110),
- Ermitteln des Zustands des vorgegebenen Schalterbereichs (110),
- Freigeben einer Bewegung der Betätigungsfläche (101) in Antwort auf die Betätigung, wenn der ermittelte Bereich (102) mit dem vorgegebenen Schalterbereich (110) korreliert und wenn dem ermittelten Zustand der aktive Zustand des Schalterbereichs (110) zugeordnet ist, wobei eine Bewegung der Betätigungsfläche nur dann möglich ist, wenn der Zustand der zugeordneten Einheit veränderbar ist, und
- Sperren der Bewegung der Betätigungsfläche (101) in Antwort auf die Betätigung, wenn der ermittelte Bereich (102) nicht mit dem vorgegebenen Schalterbereich (110) korreliert und/oder wenn dem ermittelten Zustand der passive Zustand des Schalterbereichs (110) zugeordnet ist.

2. Verfahren zum Betreiben einer Schalteranordnung (100) mit einer Betätigungsfläche (101) mit einer Mehrzahl von vorgegebenen Schalterbereichen (110, 111, 112, 113, 114, 115) mit jeweils einem aktiven Zustand, in dem eine Betätigung des Schalterbereichs (110, 111, 112, 113, 114, 115) der Mehrzahl von vorgegebenen Schalterbereichen (110, 111, 112, 113, 114, 115) einen Zustand einer dem Schalterbereich (110, 111, 112, 113, 114, 115) zugeordneten Einheit (301) ändert, und einem passiven Zustand, in dem die Betätigung des Schalterbereichs (110, 111, 112, 113, 114, 115) den Zustand der zugeordneten Einheit (301) nicht ändert, umfassend:
- Ermitteln eines Bereichs (102) der Betätigungsfläche (101), in dem die Betätigung der Schalteranordnung (100) erfolgt,
- Vergleichen des ermittelten Bereichs (102) mit der Mehrzahl von vorgegebenen Schalterbereichen (110, 111, 112, 113, 114, 115),
- Ermitteln des Zustands zumindest eines Schalterbereichs (110, 111, 112, 113, 114, 115) der Mehrzahl der Schalterbereiche (110, 111, 112, 113, 114, 115),
- Freigeben einer Bewegung der Betätigungsfläche (101) in Antwort auf die Betätigung, wenn der ermittelte Bereich (102) mit einem Schalterbereich (110, 111, 112, 113, 114, 115) der Mehrzahl von vorgegebenen Schalterbereichen (110, 111, 112, 113, 114, 115) korreliert und wenn dem ermittelten Zustand der aktive Zustand des einen Schalterbereichs (110, 111, 112, 113, 114, 115) zugeordnet ist, wobei eine Bewegung der Betätigungsfläche nur dann möglich ist, wenn der Zustand der zugeordneten Einheit veränderbar ist, und
- Sperren der Bewegung der Betätigungsfläche (101) in Antwort auf die Betätigung, wenn der ermittelte Bereich (102) nicht mit einem Schalterbereich (110, 111, 112, 113, 114, 115) der Mehrzahl von vorgegebenen Schalterbereichen (110, 111, 112, 113, 114, 115) korreliert und/oder wenn dem ermittelten Zustand des mit dem ermittelten Bereich (102) korrelierenden Schalterbereichs (110, 111, 112, 113, 114, 115) der passive Zustand zugeordnet ist.

3. Verfahren nach Anspruch 1 oder 2, bei dem die dem vorgegebenen Schalterbereich (110, 111, 112, 113, 114, 115) zugeordnete Einheit (301) aus einer Mehrzahl von dem vorgegebenen Schalterbereich (110, 111, 112, 113, 114, 115) zugeordneten Einheiten (301) ausgewählt ist.

4. Verfahren nach einem der Ansprüche 1 bis 3, bei dem das Freigeben der Bewegung ein Verändern einer Eigenschaft eines magnetorheologischen Elements (200) umfasst.

5. Schalteranordnung, umfassend:
- eine Betätigungsfläche (101) mit einem vorgegebenen Schalterbereich (110), der einen aktiven Zustand, in dem eine Betätigung des vorgegebenen Schalterbereichs (110) einen Zustand einer dem Schalterbreich (110) zugeordneten Einheit (301) ändert, und einen passiven Zustand aufweist, in dem die Betätigung des vorgegebenen Schalterbereichs (110) den Zustand der zugeordneten Einheit (301) nicht ändert,
- ein Sperrelement (103), das mit der Betätigungsfläche (101) mechanisch gekoppelt ist,
- eine Steuervorrichtung (105), die ausgebildet ist zum:
- Ermitteln eines Bereichs (102) der Betätigungsfläche (101), in dem eine Betätigung der Schalteranordnung (100) erfolgt,
- Vergleichen des ermittelten Bereichs (102) mit dem vorgegebenen Schalterbereich (110) der Betätigungsfläche (110),
- Ermitteln des Zustands des vorgegebenen Schalterbereichs (110),
- Freigeben des Sperrelements (103), so dass eine Bewegung der Betätigungsfläche (101) in Antwort auf die Betätigung freigegeben ist, wenn der ermittelte Bereich (102) mit dem vorgegebenen Schalterbereich (110) korreliert und wenn dem ermittelten Zustand des Schalterbereichs (110) der aktive Zustand zugeordnet ist , wobei eine Bewegung der Betätigungsfläche nur dann möglich ist, wenn der Zustand der zugeordneten Einheit veränderbar ist,
- Aktivieren des Sperrelements (103), so dass die Bewegung der Betätigungsfläche (101) in Antwort auf die Betätigung gesperrt ist, wenn der ermittelte Bereich (102) nicht mit dem vorgegebenen Schalterbereich (110) korreliert und/oder wenn dem ermittelten Zustand des vorgegebenen Schalterbereichs (110) der passive Zustand zugeordnet ist.

6. Schalteranordnung, umfassend:
- eine Betätigungsfläche (110) mit einer Mehrzahl von vorgegebenen Schalterbereichen (110, 111, 112, 113, 114, 115), die jeweils einen aktiven Zustand, in dem eine Betätigung des Schalterbereichs (110, 111, 112, 113, 114, 115) einen Zustand einer jeweils dem Schalterbereich (110, 111, 112, 113, 114, 115) zugeordneten Einheit (301) ändert, und einen passiven Zustand aufweisen, in dem die Betätigung des Schalterbereichs (110, 111, 112, 113, 114, 115) den Zustand der jeweiligen zugeordneten Einheit (301) nicht ändert, wobei die Steuervorrichtung (105) ausgebildet ist zum:
- Vergleichen des ermittelten Bereichs (102) mit der Mehrzahl von vorgegebenen Schalterbereichen (110, 111, 112, 113, 114, 115) der Betätigungsfläche (101),
- Ermitteln des Zustands zumindest eines Schalterbereichs (110, 111, 112, 113, 114, 115) der Mehrzahl der Schalterbereiche (110, 111, 112, 113, 114, 115),
- Freigeben des Sperrelements (103), so dass die Bewegung der Betätigungsfläche (101) in Antwort auf die Betätigung freigegeben ist, wenn der ermittelte Bereich (102) mit einem der vorgegebenen Schalterbereiche (110, 111, 112, 113, 114, 115) korreliert und wenn dem ermittelten Zustand des einen der vorgegebenen Schalterbereiche (110, 111, 112, 113, 114, 115) der aktive Zustand zugeordnet ist, , wobei eine Bewegung der Betätigungsfläche nur dann möglich ist, wenn der Zustand der zugeordneten Einheit veränderbar ist;
- Aktivieren des Sperrelements (103), so dass die Bewegung der Betätigungsfläche (101) in Antwort auf die Betätigung gesperrt ist, wenn der ermittelte Bereich (102) nicht mit einem der vorgegebenen Schalterbereiche (110, 111, 112, 113, 114, 115) korreliert und/oder wenn dem ermittelten Zustand des mit dem ermittelten Bereich (102) korrelierenden Schalterbereichs (110, 111, 112, 113, 114, 115) der passive Zustand zugeordnet ist.

7. Schalteranordnung nach Anspruch 5 oder 6, bei der das Sperrelement (103) eines umfasst aus:
- ein magnetorheologisches Element (200),
- ein Piezoelement,
- ein Elektromagnet,
- ein elektroaktives Elastomer,
- ein Ultraschallmotor.

8. Schalteranordnung nach einem der Ansprüche 5 bis 7, bei der der vorgegebene Schalterbereich (110, 111, 112, 113, 114, 115) eine Anzeigevorrichtung (106) zur Darstellung der zugeordneten Einheit (301) aufweist.

9. Schalteranordnung nach einem der Ansprüche 5 bis 8, umfassende ein Gehäuse (208), bei der das Sperrelement (103) mit dem Gehäuse (208) gekoppelt ist und bei der die Betätigungsfläche (101) relativ zu dem Gehäuse (208) quer zur Hauptausbreitungsrichtung der Betätigungsfläche (101) beweglich angeordnet ist.

10. Kraftfahrzeug, umfassend eine Schalteranordnung (100) nach einem der Ansprüche 5 bis 9, bei der die zugeordnete Einheit (301) eine Einheit des Kraftfahrzeugs (300) ist.

## Claims

1. A method for operating a switch arrangement (100), comprising an actuation surface (101) with a predefined switch region (110) having an active state, in which an actuation of the predefined switch region (110) modifies a state of an associated unit (301), and a passive state, in which the actuation of the predefined switch region (110) does not modify the state of the associated unit (301), the method comprising the following steps:
- determining a region (102) of the actuation surface (101) in which the switch arrangement (100) is actuated;
- comparing the determined region (102) with the predefined switch region (110);
- determining the state of the predefined switch region (110);
- releasing a movement of the actuation surface (101) in response to the actuation if the determined region (102) correlates with the predefined switch region (110) and if the active state of the switch region (110) is associated with the determined state, a movement of the actuation surface being possible only if the state of the associated unit is modifiable; and
- locking the movement of the actuation surface (101) in response to the actuation if the determined region (102) does not correlate with the predefined switch region (110) and/or if the passive state of the switch region (110) is associated with the determined state.

2. A method for operating a switch arrangement (100), comprising an actuation surface (101) with a plurality of predefined switch regions (110, 111, 112, 113, 114, 115) each having an active state, in which an actuation of the switch region (110, 111, 112, 113, 114, 115) of the plurality of predefined switch regions (110, 111, 112, 113, 114, 115) modifies a state of a unit (301) associated with the switch region (110, 111, 112, 113, 114, 115), and a passive state, in which the actuation of the switch region (110, 111, 112, 113, 114, 115) does not modify the state of the associated unit (301), the method comprising the following steps:
- determining a region (102) of the actuation surface (101) in which the switch arrangement (100) is actuated;
- comparing the determined region (102) with the plurality of predefined switch regions (110, 111, 112, 113, 114, 115);
- determining the state of at least one switch region (110, 111, 112, 113, 114, 115) of the plurality of switch regions (110, 111, 112, 113, 114, 115);
- releasing a movement of the actuation surface (101) in response to the actuation if the determined region (102) correlates with a switch region (110, 111, 112, 113, 114, 115) of the plurality of predefined switch regions (110, 111, 112, 113, 114, 115) and if the active state of the switch region (110, 111, 112, 113, 114, 115) is associated with the determined state, a movement of the actuation surface being possible only if the state of the associated unit is modifiable; and
- locking the movement of the actuation surface (101) in response to the actuation if the determined region (102) does not correlate with a switch region (110, 111, 112, 113, 114, 115) of the plurality of predefined switch regions (110, 111, 112, 113, 114, 115) and/or if the passive state is associated with the determined state of the switch region (110, 111, 112, 113, 114, 115) correlating with the determined region (102).

3. A method according to claim 1 or 2, in which the unit (301) associated with the predefined switch region (110, 111, 112, 113, 114, 115) is selected from a plurality of units (301) associated with the predefined switch region (110, 111, 112, 113, 114, 115).

4. A method according to any one of claims 1 to 3, in which the release of the movement comprises a modification to a property of a magnetorheological element (200).

5. A switch assembly comprising:
- an actuation surface (101) with a predefined switch region (110), which has an active state, in which an actuation of the predefined switch region (110) modifies a state of a unit (301) associated with the switch region (110), and a passive state, in which the actuation of the predefined switch region (110) does not modify the state of the associated unit (301);
- a blocking element (103), which is mechanically coupled to the actuation surface (101);
- a control device (105), which is configured to:
- determine a region (102) of the actuation surface (101) in which the switch arrangement (100) is actuated;
- compare the determined region (102) with the predefined switch region (110) of the actuation surface (101);
- determine the state of the predefined switch region (110);
- release the blocking element (103) such that a movement of the actuation surface (101) in response to the actuation is released if the determined region (102) correlates with the predefined switch region (110) and if the active state is associated with the determined state of the switch region (110), a movement of the actuation surface being possible only if the state of the associated unit is modifiable; and
- activate the blocking element (103) such that the movement of the actuation surface (101) is locked in response to the actuation if the determined region (102) does not correlate with the predefined switch region (110) and/or if the passive state is associated with the determined state of the predefined switch region (110).

6. A switch assembly comprising:
- an actuation surface (101) with a plurality of predefined switch regions (110, 111, 112, 113, 114, 115), which each have an active state, in which an actuation of the switch region (110, 111, 112, 113, 114, 115) modifies a state of a unit (301) associated with the switch region (110, 111, 112, 113, 114, 115), and a passive state, in which the actuation of the switch region (110, 111, 112, 113, 114, 115) does not modify the state of the associated unit (301), the control device (105) being configured to:
- compare the determined region (102) with the plurality of predefined switch regions (110, 111, 112, 113, 114, 115) of the actuation surface (101);
- determine the state of at least one switch region (110, 111, 112, 113, 114, 115) of the plurality of switch regions (110, 111, 112, 113, 114, 115);
- release the blocking element (103) such that the movement of the actuation surface (101) in response to the actuation is released if the determined region (102) correlates with one of the predefined switch regions (110, 111, 112, 113, 114, 115) and if the active state is associated with the determined state of the one of the predefined switch regions (110, 111, 112, 113, 114, 115), a movement of the actuation surface being possible only if the state of the associated unit is modifiable; and
- activate the blocking element (103) such that the movement of the actuation surface (101) is locked in response to the actuation if the determined region (102) does not correlate with one of the predefined switch regions (110, 111, 112, 113, 114, 115) and/or if the passive state is associated with the determined state of the switch region (110, 111, 112, 113, 114, 115) correlating with the determined region (102).

7. A switch assembly according to claim 5 or 6, in which the blocking element (103) comprises one of the following:
- a magnetorheological element (200);
- a piezo element;
- an electromagnet;
- an electroactive elastomer;
- an ultrasonic motor.

8. A switch assembly according to one of claims 5 to 7, in which the predefined switch region (110, 111, 112, 113, 114, 115) comprises a display device (106) for displaying the associated unit (301).

9. A switch assembly according to one of claims 5 to 8, comprising a housing (208), in which the blocking element (103) is coupled to the housing (208) and in which the actuation surface (101) is arranged so as to be movable relative to the housing (208) transversely to the main direction of extent of the actuation surface (101).

10. A motor vehicle, comprising a switch assembly (100) according to any one of claims 5 to 9, in which the associated unit (301) is a unit of the motor vehicle (300).

## Revendications

1. Procédé de gestion d'un dispositif de commutateur (100) comprenant une surface d'actionnement (101) comportant un domaine de commutateur (110) prédéfini ayant un état actif dans lequel un actionnement du domaine de commutateur (110) prédéfini modifie l'état d'une unité (301) associée, et un état passif dans lequel l'actionnement du domaine de commutateur (110) prédéfini ne modifie pas l'état de l'unité (301) associée, comprenant des étapes consistant à :
- déterminer un domaine (102) de la surface d'actionneme+nt (101) dans lequel l'actionnement du dispositif de commutateur (100) est effectué,
- comparer le domaine (102) déterminé avec le domaine de commutateur (110) prédéfini,
- déterminer l'état du domaine de commutateur (110) prédéfini,
- libérer un déplacement de la surface d'actionnement (101) en réponse à l'actionnement, lorsque le domaine (102) déterminé est en corrélation avec le domaine de commutateur (110) prédéfini, et lorsqu'au domaine déterminé est associé l'état actif du domaine de commutateur (110), un déplacement de la surface d'actionnement n'étant possible que lorsque l'état de l'unité associée peut être modifié, et
- bloquer le déplacement de la surface d'actionnement (101) en réponse à l'actionnement lorsque le domaine (102) déterminé n'est pas en corrélation avec le domaine de commutateur (110) prédéfini et/ou lorsqu'à l'état déterminé est associé l'état passif du domaine de commutateur (110).

2. Procédé de gestion d'un dispositif de commutateur (100) comprenant une surface d'actionnement (101) comportant une série de domaines de commutateur (110, 111, 112, 113, 114, 115) prédéfinis ayant chacun un état actif dans lequel un actionnement du domaine de commutateur (110, 111, 112, 113, 114, 115) de la série de domaines de commutateur prédéfinis (110, 111, 112, 113, 114, 115) modifie l'état d'une unité (301) associée au domaine de commutateur (110, 111, 112, 113, 114, 115), et un état passif dans lequel l'actionnement d'un domaine de commutateur (110, 111, 112, 113, 114, 115) ne modifie pas l'état de l'unité (301) associée, comprenant des étapes consistant à :
- déterminer un domaine (102) de la surface d'actionnement (101) dans lequel l'actionnement du dispositif de commutateur (100) est effectué :
- comparer le domaine (102) déterminé avec la série de domaines de commutateur (110, 111, 112, 113, 114, 115) prédéfinie,
- déterminer l'état d'au moins un domaine de commutateur (110, 111, 112, 113, 114, 115) de la série de domaines de commutateur (110, 111, 112, 113, 114, 115),
- libérer un déplacement de la surface d'actionnement (101) en réponse à l'actionnement lorsque le domaine (102) déterminé est en corrélation avec un domaine de commutateur (110, 111, 112, 113, 114, 115) de la série de domaines de commutateur (110, 111, 112, 113, 114, 115) prédéfinie et lorsque à l'état déterminé est associé l'état actif du domaine de commutateur (110, 111, 112, 113, 114, 115), un déplacement de la surface d'actionnement n'étant possible que lorsque l'état de l'unité associée peut être modifié, et
- bloquer le déplacement de la surface d'actionnement (101) en réponse à l'actionnement lorsque le domaine (102) déterminé n'est pas en corrélation avec un domaine de commutateur (110, 111, 112, 113, 114, 115) de la série de domaines de commutateur (110, 111, 112, 113, 114, 115) prédéfinie, et/ou lorsque à l'état déterminé du domaine de commutateur (110, 111, 112, 113, 114, 115) en corrélation avec le domaine (102) déterminé est associé l'état passif.

3. Procédé conforme à la revendication 1 ou 2,
selon lequel l'unité (301) associée au domaine de commutateur (110, 111, 112, 113, 114, 115) prédéfini est choisie dans une série d'unités (301) associées au domaine de commutateur (110, 111, 112, 113, 114, 115) prédéfini.

4. Procédé conforme à l'une des revendications 1 à 3,
selon lequel la libération du déplacement comprend une modification d'une propriété d'un élément magnétorhéologique (200).

5. Dispositif de commutateur comprenant :
- une surface d'actionnement (101) comportant un domaine de commutateur (110) prédéfini ayant un état actif dans lequel un actionnement du domaine de commutateur (110) prédéfini modifie l'état d'une unité (301) associée au domaine de commutateur (110) et un état passif dans lequel l'actionnement du domaine de commutateur (110) prédéfini ne modifie pas l'état de l'unité (301) associée,
- un élément de blocage (103) qui est couplé mécaniquement à la surface d'actionnement (101),
- un dispositif de commande (105) qui est réalisé pour permettre de :
- déterminer un domaine (102) de la surface d'actionnement (101) dans lequel un actionnement du dispositif de commutateur (100) est effectué,
- comparer le domaine (102) déterminé avec le domaine de commutateur (110) prédéfini de la surface d'actionnement (110),
- déterminer l'état du domaine de commutateur (110) prédéfini,
- libérer l'élément de blocage (103) de sorte qu'un déplacement de la surface d'actionnement (101) soit libéré en réponse à l'actionnement lorsque le domaine (102) déterminé est en corrélation avec le domaine de commutateur (110) prédéfini, et lorsqu'à l'état déterminé du domaine de commutateur (110) est associé l'état actif, un déplacement de la surface d'actionnement n'étant possible que lorsque l'état de l'unité associée peut être modifié,
- activer l'élément de blocage (103) de sorte que le déplacement de la surface d'actionnement (101) soit bloqué en réponse à l'actionnement lorsque le domaine (102) déterminé n'est pas en corrélation avec le domaine de commutateur (110) prédéfini et/ou lorsqu'à l'état déterminé du domaine de commutateur (110) prédéfini est associé l'état passif.

6. Dispositif de commutateur comprenant :
- une surface d'actionnement (110) comportant une série de domaines de commutateur (110, 111, 112, 113, 114, 115) prédéfinie ayant chacun un état actif dans lequel un actionnement du domaine de commutateur (110, 111, 112, 113, 114, 115) modifie l'état d'une unité (301) respectivement associée au domaine de commutateur (110, 111, 112, 113, 114, 115), et un état passif dans lequel l'actionnement du domaine de commutateur (110, 111, 112, 113, 114, 115) ne modifie pas l'état de l'unité (301) respectivement associée, un dispositif de commande (105) étant réalisé pour permettre :
- de comparer le domaine (102) déterminé avec la série de domaines de commutateurs (110, 111, 112, 113, 114, 115) déterminée de la surface d'actionnement (101),
- déterminer l'état d'au moins un domaine de commutateur (110, 111, 112, 113, 114, 115) de la série de domaines de commutateur (110, 111, 112, 113, 114, 115),
- libérer un élément de blocage (103) de sorte que le déplacement de la surface d'actionnement (101) soit libéré en réponse à l'actionnement lorsque le domaine (102) déterminé est en corrélation avec l'un des domaines de commutateur (110, 111, 112, 113, 114, 115) prédéfinis et lorsqu'à l'état déterminé du domaine de commutateur (110, 111, 112, 113, 114, 115) prédéfini est associé l'état actif, un déplacement de la surface d'actionnement n'étant possible que lorsque l'état de l'unité associée peut être modifié,
- activer l'élément de blocage (103) de sorte que le déplacement de la surface d'actionnement (101) soit bloqué en réponse à l'actionnement lorsque le domaine (102) déterminé n'est pas en corrélation avec l'un des domaines de commutateur (110, 111, 112, 113, 114, 115) prédéfinis et/ou lorsqu'à l'état déterminé du domaine de commutateur (110, 111, 112, 113, 114, 115) en corrélation avec le domaine (102) déterminé est associé l'état passif.

7. Dispositif de commutateur conforme à la revendication 5 ou 6, dans lequel l'élément de blocage (103) est constitué :
- d'un élément magnétorhéologique (200),
- d'un élément piézoélectrique,
- d'un électroaimant,
- d'un élastomère électro-actif,
- d'un moteur à ultrasons.

8. Dispositif de commutateur conforme à l'une des revendications 5 à 7,
dans lequel le domaine de commutateur (110, 111, 112, 113, 114, 115) prédéfini comporte un dispositif d'affichage (106) permettant de représenter l'unité (301) associée.

9. Dispositif de commutateur conforme à l'une des revendications 5 à 8, comprenant un boîtier (208) dans lequel l'élément de blocage (103) est couplé au boîtier (208) et dans lequel la surface d'actionnement (101) est montée mobile par rapport au boîtier (208) transversalement à la direction d'extension principale de cette surface d'actionnement (101).

10. Véhicule automobile comprenant un dispositif de commutateur (100) conforme à l'une des revendications 5 à 9,
dans lequel l'unité (301) associée est une unité du véhicule (300).
